Europäisches Patentamt

European Patent Office

Office européen des brevets

(11) Numéro de publication: **0 122 182**
A1

# (12) DEMANDE DE BREVET EUROPEEN

(21) Numéro de dépôt: **84400557.9**

(22) Date de dépôt: **20.03.84**

(51) Int. Cl.³: **H 01 J 1/20,** H 01 J 37/07

(30) Priorité: **07.04.83 FR 8305675**

(43) Date de publication de la demande: **17.10.84**
**Bulletin 84/42**

(84) Etats contractants désignés: **BE DE FR GB IT**

(71) Demandeur: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Gallay, Alain, 1, rue du Four à Pain Jouy Le Moutier, F-95000 Cergy (FR)**
Inventeur: **Hamon, Jean Pierre, La Hayette 4 rue du Pré aux Renards, Jouy le Moutier F-95000 Cergy (FR)**

(74) Mandataire: **Jacobson, Claude et al, L'AIR LIQUIDE, SOCIETE ANONYME POUR L'ETUDE ET L'EXPLOITATION DES PROCEDES GEORGES CLAUDE 75, quai d'Orsay, F-75321 Paris Cedex 07 (FR)**

(54) **Cathode pour canon à électrons.**

㊲ La pastille émissive (2) en LaB est logée dans un boîtier (1, 5) en tantale ouvert seulement vers l'avant et chauffé par l'arrière par un filament. Entre les surfaces périphérique et arrière de la pastille et les surfaces en regard du boîtier sont interposés des morceaux de feuille de graphite (3, 4) qui empêchent les atomes de bore de migrer dans le tantale, ce qui prolonge la durée de vie de la cathode.

Application aux installations de soudage par faisceau d'électrons.

EP 0 122 182 A1

La présente invention se rapporte à une cathode pour canon à électrons, du type comprenant une pastille émissive portée par un boîtier ouvert sur sa face avant, destiné à être chauffé par sa face arrière et constitué d'un métal dans lequel certains atomes de la pastille émissive diffusent aux températures d'utilisation, notamment une pastille émissive en hexaborure de lanthane portée par un boîtier en tantale.

Les cathodes de ce type comprenant une pastille émissive en $LaB_6$ (hexaborure de lanthane) portée par un boîtier en tantale sont largement utilisées dans les installations de soudage par faisceau d'électrons. Un inconvénient de ces cathodes réside dans leur durée de vie limitée ; ceci est dû notamment à l'usure de la pastille émissive qui résulte de la migration dans le tantale des atomes de bore du $LaB_6$. A la suite de cette migration, il se produit une détérioration des surfaces porteuses de la pastille émissive, ce qui conduit à une modification du positionnement de cette pastille, et, par suite, à une baisse de constance dans la qualité des soudures réalisées.

L'invention a pour but d'éviter de façon particulièrement simple et économique ce phénomène indésirable. A cet effet, elle a pour objet une cathode du type précité, caractérisée en ce qu'elle comporte un ou plusieurs morceaux de feuille de graphite insérés entre des surfaces en regard de la pastille et du boîtier.

Lorsque la pastille est cylindrique, la cathode comprend avantageusement un premier morceau de feuille de graphite mis sous forme cylindrique et un second morceau de feuille de graphite en forme de disque appliqué sur la face arrière de la pastille.

Un exemple de réalisation de l'invention va maintenant être décrit en regard du dessin annexé, sur lequel :

- la figure 1 est une vue en perspective éclatée d'une cathode conforme à l'invention ; et
- la figure 2 est une vue en coupe longitudinale de cette cathode après son montage.

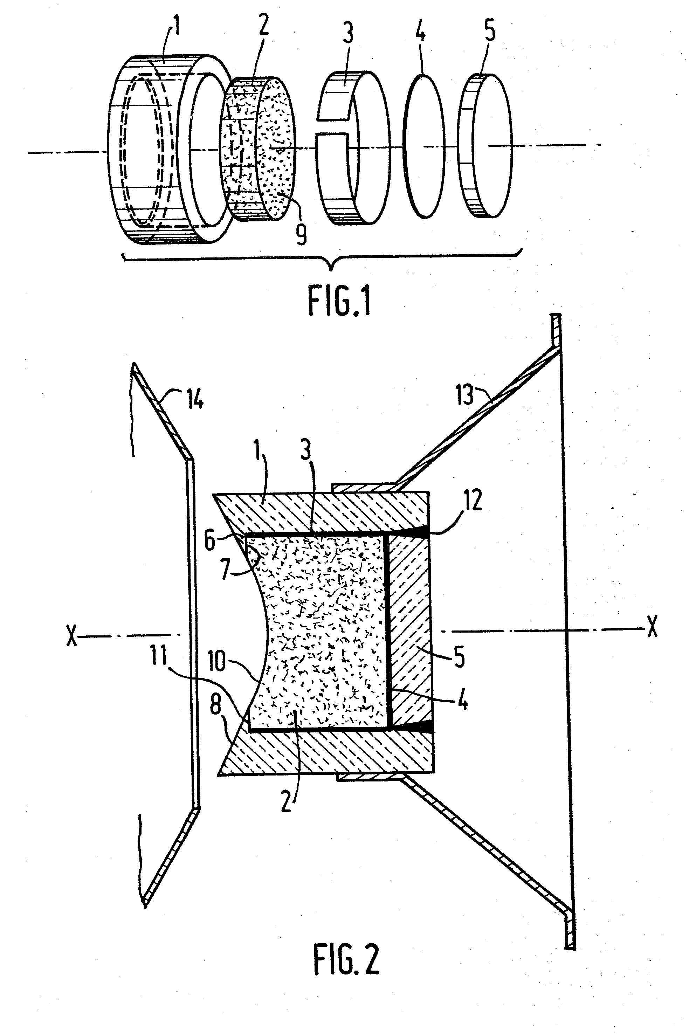

La cathode représentée aux figures 1 et 2 est destinée à être utilisée dans le canon à électrons d'une installation de soudage par faisceau d'électrons. Elle est constituée d'un fourreau 1 en tantale, d'une pastille émissive 2 en $LaB_6$, de deux morceaux de feuille de graphite 3 et 4 et d'un couvercle 5. Tous ces éléments ont une symétrie de révolution autour d'un axe commun X-X.

Le fourreau 1 est un tube cylindrique qui présente à son extrémité avant une collerette intérieure 6. La face arrière 7 de cette collerette est plane et perpendiculaire à l'axe X-X, tandis que sa face avant 8 est tronconique et diverge vers l'avant.

La pastille 2 est cylindrique. Son diamètre, de l'ordre de quelques millimètres, est légèrement inférieur au diamètre intérieur du fourreau 1. Sa face arrière 9 est plane et perpendiculaire à l'axe X-X, tandis que sa face avant est creuse et présente une surface active sphérique 10 bordée d'une plage périphérique plane 11 conjuguée de la face 7 du fourreau 1.

Le morceau de feuille de graphite 3 est un ruban dont la largeur et la longueur correspondent respectivement à la hauteur et au périmètre de la pastille 2. Le morceau de feuille de graphite 4 est un disque de même rayon que la pastille 2.

Le couvercle 5 est un disque plein en tantale qui s'ajuste étroitement dans la partie arrière du fourreau 1.

Pour assembler la cathode, on enfile la pastille 2 dans le fourreau 1 jusqu'à ce que sa plage périphérique 11 s'appuie sur la face arrière 7 de la collerette 6. On met ensuite le ruban 3 sous une forme cylindrique, et on l'enfile dans l'intervalle annulaire resté libre entre la pastille et le fourreau. Puis on pose le disque 4 sur la face arrière 9 de la pastille, on applique le couvercle 5 sur ce disque, et on fixe la périphérie de ce couvercle au fourreau 1 par une soudure 12 réalisée par soudage par faisceau d'électrons.

La cathode ainsi assemblée est montée à l'extrémité avant d'un porte-cathode en tantale 13 à axe horizontal faisant partie d'un canon à électrons. La face avant 8 du fourreau 1 prolonge le Wenhelt 14 du canon et se raccorde tangentiellement à la face sphérique 10 de la pastille.

En service, la cathode est chauffée par un filament (non représenté) qui envoie un flux d'électrons sur la face arrière du couvercle 5. L'énergie de chauffage est transmise à la face active 10 de la pastille 2, d'une part axialement à travers le couvercle 5, le disque 4 et la pastille, d'autre part par conduction à travers le couvercle 5 dans le sens radial puis à travers la longueur du fourreau 1.

Grâce à la présence des morceaux de feuille de graphite 3 et 4, la quasi-totalité des surfaces de la pastille 2 qui se trouvent en regard du tantale sont séparées de ce métal par une barrière de graphite qui empêche les atomes de bore de migrer dans le tantale. Ces surfaces sont ainsi protégées des détériorations mécaniques consécutives à cette migration ; en particulier, la surface cylindrique de la pastille reste parfaitement cylindrique, et le positionnement initial de la surface active 10 reste inchangé pendant une temps relativement long. La constance de la qualité des soudures réalisées au moyen d'un tel canon à électrons est par suite améliorée.

Par ailleurs, le disque 4 apporte un autre avantage important : la présence d'une feuille de graphite et de deux interfaces 4 - 5 et 4 - 2 entre le filament de chauffage et la pastille diminue le flux de chaleur transmis axialement vers la face active 10 et augmente celui qui est transmis latéralement par conduction par le couvercle 5 et le fourreau 1. Par conséquent, la pastille 2 est chauffée de façon plus uniforme et est le siège de gradients de température moins abrupts. Il s'ensuit qu'une température moins élevée de la face arrière 9 de la pastille est nécessaire pour obtenir une température de consigne de la face active 10. Ceci est bien entendu favorable à l'augmentation de la durée de vie de la cathode.

Dans cette optique, il est possible, en variante, de régler l'épaisseur du disque 4, par exemple en empilant plusieurs morceaux circulaires de feuille de graphite à cet emplacement.

En variante encore, on peut ajouter à la cathode un étroit anneau de feuille de graphite interposé entre la face arrière 7 de la collerette 6 du fourreau 1 et la plage plane 11 de la pastille 2. Toutes les surfaces de cette dernière situées en regard du tantale sont alors protégées, au sens indiqué plus haut. Ceci est particulièrement souhaitable lorsque les conditions de travail conduisent à une réaction importante de l'hexaborure de lanthane avec le support 1 - 5 de la pastille, du fait de la température nécessaire pour la densité d'émission requise et/ou du fait du métal constituant le support. Le support 1 - 5 peut en effet être réalisé en d'autres métaux, notamment en molybdène ou en tungstène.

4

0122182

REVENDICATIONS

1. - Cathode pour canon à électrons, du type comprenant une pastille émissive (2) portée par un boîtier (1, 5) ouvert sur sa face avant, destiné à être chauffé par sa face arrière et constitué d'un métal dans lequel certains atomes de la pastille émissive diffusent aux températures d'utilisation, notamment une pastille émissive en hexaborure de lanthane portée par un boîtier en tantale, caractérisée en ce qu'elle comporte un ou plusieurs morceaux de feuille de graphite (3, 6) insérés entre des surfaces en regard de la pastille et du boîtier.

2. - Cathode suivant la revendication 1, caractérisée en ce que le ou les morceaux de feuille de graphite (3, 4) sont prévus au moins dans la région la plus proche de la face arrière (5) du boîtier (1, 5).

3. - Cathode suivant la revendication 2, dans laquelle la pastille (2) est cylindrique, caractérisée en ce qu'elle comprend un premier morceau (3) de feuille de graphite mis sous forme cylindrique et un second morceau (4) de feuille de graphite en forme de disque appliqué sur la face arrière de la pastille.

4. - Cathode suivant la revendication 3, caractérisée en ce qu'elle comprend en outre un ou plusieurs disques supplémentaires de feuille de graphite superposés audit second morceau.

5. - Cathode suivant l'une quelconque des revendications 1 à 4, dans laquelle la pastille (2) est positionnée axialement par butée d'une plage périphérique (11) de sa face avant contre une collerette (6) du boîtier (1, 5), caractérisée en ce qu'elle comprend un anneau de feuille de graphite interposé entre cette plage et cette collerette.

6. - Cathode suivant l'une quelconque des revendications 2 à 5, caractérisée en ce que le boîtier (1, 5) est fermé sur sa face arrière par un disque plein (5).

1/1

FIG.1

FIG.2

**Office européen des brevets**

## RAPPORT DE RECHERCHE EUROPEENNE

EP  84 40 0557

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | FR-A-2 106 968  (ALCATEL)<br>* Figure; page 2, ligne 5 - page 4, ligne 13 * | 1 | H 01 J    1/20<br>H 01 J   37/07 |
| A | JOURNAL OF ELECTRON MICROSCOPY, vol. 24, no. 4, 1975, pages 275-277, Tokyo, JP; S. NAKAGAWA et al.: "A low heating power LaB6 cathode gun with control system for scanning electron microscope"<br>* En entier * | 1 | |
| A | FR-A-2 395 600  (INSTITUT ELEKTROSVARKI IMENI E.O. PATONA AKADEMII NAUK UKRAINSKOI SSR)<br>* Figure  1;  page 4, ligne 25 - page 6, ligne 1 * | 1 | |
| A | JAPANESE JOURNAL OF APPLIED PHYSICS, vol. 20, no. 2, février 1981, pages 341-345, Tokyo, JP; T. SHINTAKE et al.: "Pierce-type electron gun with a large concave LaB6 cathode"<br>* Pages 341-343, paragraphe 2 * | 1 | |

**DOMAINES TECHNIQUES RECHERCHES (Int. Cl. ³)**

H 01 J    1
H 01 J    3
H 01 J   37

Le présent rapport de recherche a été établi pour toutes les revendications

| Lieu de la recherche<br>LA HAYE | Date d'achèvement de la recherche<br>27-06-1984 | Examinateur<br>SCHAUB G.G. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant